# FASCICULE DE BREVET EUROPEEN

(11) **EP 1 332 555 B1**
(45) Date de publication et mention de la délivrance du brevet: **26.10.2005**
(21) Numéro de dépôt: 00972525.0
(22) Date de dépôt: 10.11.2000
(51) Int. Cl.: H03M 1/00

(54) **CONVERTISSEUR ANALOGIQUE-NUMERIQUE ET NUMERIQUE-ANALOGIQUE**
ANOLOG-DIGITALWANDLER UND DIGITAL-ANALOGWANDLER
ANALOG-TO-DIGITAL AND DIGITAL-TO-ANALOG CONVERTER

(43) Date de publication de la demande: 06.08.2003
(73) Titulaire: Xemics SA, 2007 Neuchâtel (CH)
(72) Inventeur: WOUTERS, Sietse, Engelbregt, CH-2036 Cormondrèche (CH)
(74) Mandataire: P&TS Patents & Technology Surveys SA
(86) Numéro de dépôt international: PCT/CH2000/000600
(87) Numéro de publication internationale: WO 2002/039588

(56) Documents cités:
- US-A- 6 075 478
- CASTELLO R ET AL: "Analog front-end of an ECBM transceiver for ISDN" PROCEEDINGS OF THE IEEE 1989 CUSTOM INTEGRATED CIRCUITS CONFERENCE (CAT. NO.89CH2671-6), SAN DIEGO, CA, USA, 15-18 MAY 1989, pages 16.4/1-4, XP002173801 1989, New York, NY, USA, IEEE, USA
- PATENT ABSTRACTS OF JAPAN vol. 1999, no. 04, 30 avril 1999 (1999-04-30) -& JP 11 008595 A (NIPPON TELEGR &TELEPH CORP <NTT>), 12 janvier 1999 (1999-01-12)

## Description

La présente invention concerne un convertisseur analogique-numérique et numérique-analogique, ou codec (codeur-décodeur), en particulier un convertisseur réalisé sous la forme d'un composant discret. La présente invention concerne notamment un codec destiné à l'acquisition et à la restitution de signaux vocaux dans un dispositif électriquement autonome.

De nombreux appareils connus nécessitent un circuit d'acquisition et de restitution de signaux vocaux. Citons à titre d'exemples non limitatifs des téléphones portables ou sans fils, des prothèses auditives, des appareils d'enregistrements numériques tels que dictaphones, des appareils commandés par la voix, des casques à écouteurs, etc. Ces appareils possèdent en commun un circuit de conversion analogique-numérique apte à convertir les signaux analogiques fournis par un transducteur, par exemple un microphone, en signaux numériques traités par un microprocesseur ou un processeur de traitement de signal (DSP). Si l'appareil est destiné à restituer des sons générés ou traités par le processeur, il comporte également un circuit de conversion numérique analogique destiné à convertir les signaux numériques du microprocesseur en signaux analogiques capables d'attaquer un élément de restitution, par exemple un haut-parleur. Il est connu d'intégrer dans un même composant discret le circuit de conversion analogique-numérique et le circuit de conversion numérique-analogique d'un appareil: on parle alors de codec (codeur-décodeur).

Afin de réduire le débit de données numériques à la sortie du processeur de traitement de signal, et donc d'économiser la bande passante d'un canal de transmission ou l'espace mémoire d'un support d'enregistrement de ces données, il est déjà connu de réaliser ou de programmer le microprocesseur de manière à ce qu'il interrompe le traitement de signal lorsque aucun signal vocal n'est capté par le microphone. Il a en effet été constaté dans une application de téléphonie typique que le temps de parole de chaque interlocuteur est inférieur à 50% du temps total de la communication. Cette caractéristique des signaux de parole a été utilisée pour comprimer les données numériques transmises.

Dans ce but, on connaît des processeurs de traitement de signal comportant un circuit ou un module informatique qui permet de détecter la présence ou l'absence de voix, et d'interrompre la transmission ou le stockage des données en l'absence de voix.

Le processeur de traitement de signal doit néanmoins rester alimenté en permanence afin d'effectuer cette détection, ce qui s'avère en particulier désavantageux dans un dispositif à faible autonomie électrique. Par ailleurs, la plupart des processeurs disponibles commercialement sur le marché sont dépourvus de circuit de détection de voix, ce qui limite considérablement le choix de processeurs utilisables pour une application donnée, ou nécessite de réaliser cette fonction en la programmant sur un microprocesseur existant. Un module de détection de voix réalisé par logiciel doit toutefois traiter les données du codec en temps réel et sollicite par conséquent fortement la mémoire et la capacité de calcul du microprocesseur.

On connaît également des circuits réalisés sous la forme de composants discrets qui fournissent un signal indiquant l'absence ou la présence de voix dans un flux de données analogique ou numérique. Les algorithmes et les circuits mis en oeuvre dans ce type de circuits spécialisés sont toutefois complexes et permettent notamment de distinguer entre un silence, une voix ou un bruit, par exemple en mesurant des niveaux d'énergie ou des puissances dans une ou plusieurs bandes de fréquence. De tels circuits sont donc relativement onéreux, complexes à mettre en oeuvre et consomment un courant électrique important. Par ailleurs, la présence d'un circuit électronique discret supplémentaire entre le codec et le microprocesseur est souvent indésirable dans des dispositifs portables miniaturisés. Enfin, ces circuits sont inadaptés au traitement de signaux numériques transmis de manière sérielle entre le codec et le processeur numérique.

Le document US6075478 décrit un convertisseur analogique numérique à approximations successives comprenant un comparateur pour inhiber la conversion et mettre le convertisseur en un état de veille lorsque le signal d'entrée est jugée comme non efficace.

Le document JP11008595 concerne un codec vocal dans qui peut être mis en état de veille afin de réduire sa consommation énergétique.

L'article « Analog Front-End of an ECBM Transceiver for ISDN » de Castello *et al*. publié dans les comptes-rendus de « IEEE1989 Custom integrated circuits conference, San Diego, USA » , 15-18 mai 1989, décrit l'interface analogique d'un circuit transcéiver pour un système téléphonique RNIS prévoyant un mode de veille à basse consommation.

Un but de la présente invention est donc d'éviter les inconvénients mentionnés ci-dessus.

Selon l'invention, ces buts sont atteints au moyen d'un convertisseur analogique-numérique et/ou numérique-analogique comportant les caractéristiques indiquées dans les revendications indépendantes, des variantes préférentielles étant par ailleurs mentionnées dans les revendications dépendantes.

En particulier, ces buts sont atteints au moyen d'un convertisseur analogique-numérique réalisé sous la forme d'un composant électronique discret, comportant notamment un circuit de détection de signal pour détecter puis indiquer hors du composant la présence ou l'absence de données significatives dans la séquence d'échantillons numériques générée par le circuit de conversion.

En intégrant le circuit de détection de signal dans le convertisseur analogique-numérique, plutôt que dans le processeur de traitement de signal, on peut ainsi générer un signal de mode de veille qui peut être utilisé pour désactiver sélectivement les composants en aval du convertisseur, notamment le processeur lui-même. Cette solution permet en outre au circuit de détection de signal de traiter les données converties sous forme numérique et en parallèle; il est donc possible de réaliser un circuit très simple, occupant peu de surface de silicium et nécessitant une consommation électrique réduite.

Le circuit de détection de signal peut par exemple comporter un comparateur numérique pour comparer chaque échantillon de la séquence numérique avec une valeur de seuil. Un tel comparateur peut être réalisé en occupant une surface très réduite. Afin d'éviter des variations trop rapides du signal de mode de veille, un accumulateur est de préférence prévu pour intégrer le signal à la sortie du comparateur numérique. Un tel accumulateur peut être réalisé de manière économique au moyen d'un simple compteur.

Les buts de l'invention sont également atteints au moyen d'un convertisseur numérique-analogique réalisé sous la forme d'un composant électronique discret, comportant notamment un circuit de détection de signal pour détecter puis indiquer hors du composant la présence ou l'absence de données significatives dans la séquence d'échantillons numériques reçue.

L'invention sera mieux comprise à la lecture de la description donnée à titre d'exemple et illustrée par les figures annexées qui montrent:
La figure 1 un système d'acquisition, de traitement et de restitution de données audio, comprenant un codec, un processeur et un module haute fréquence.
La figure 2 un convertisseur analogique-numérique et numérique analogique selon l'invention.
La figure 3 différents chronogrammes illustrant l'évolution des signaux dans le système de l'invention.

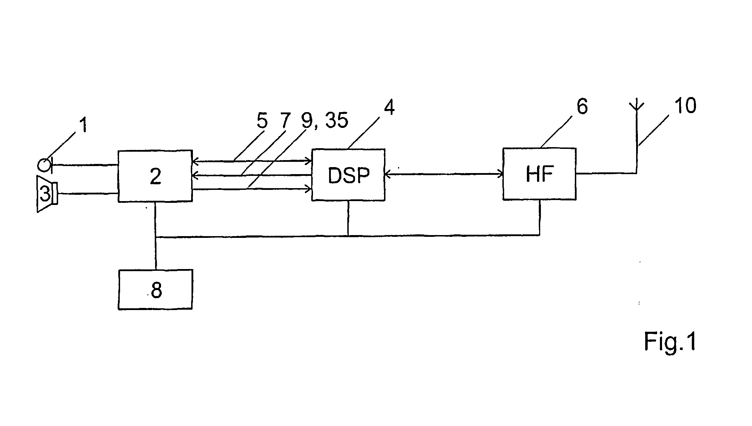

La figure 1 illustre de manière schématique un système utilisant un codec 2 selon l'invention. Le codec 2 permet d'acquérir et de numériser des données analogiques provenant d'un transducteur 1, par exemple un microphone, et de convertir des signaux numériques en signaux analogiques aptes à être restitués par un haut-parleur 3. Le codec 2 échange des données audio numériques au travers d'une ligne audio sérielle 5 avec un processeur 4, par exemple un processeur de traitement de signal ou un microcontrôleur. Le comportement du codec 2 peut être contrôlé par le processeur au moyen d'une ligne de contrôle sérielle 7. Des signaux de mode de veille 9, 35 fournis par le codec 2 au microprocesseur 4 permettent à ce dernier de mettre sélectivement certains composants du système en mode de veille, comme on le verra plus loin.

Les données acquises par le microphone 1 et numérisées par le codec 2 sont traitées par le processeur 4, par exemple pour les filtrer, les mémoriser, détecter des événements particuliers, etc., et peuvent être transmises par un module de communication 6 au travers d'un canal de communication, dans l'exemple illustré un canal radio utilisant une antenne 10. Inversement, les données reçues par le module 6 peuvent être traitées par le processeur 4 et converties en signaux analogiques par le codec 2 pour être restituées sous la forme de signaux vocaux par le haut-parleur 3. L'ensemble du système est alimenté au moyen d'une batterie ou d'une cellule 8. Le codec 2, le microprocesseur 4 et le module de communication 6 sont de préférence réalisés sous la forme de composants (circuits intégrés) discrets montés par exemple sur une carte de circuit imprimé (à l'exclusion de la partie haute fréquence). Le système peut inclure d'autres composants.

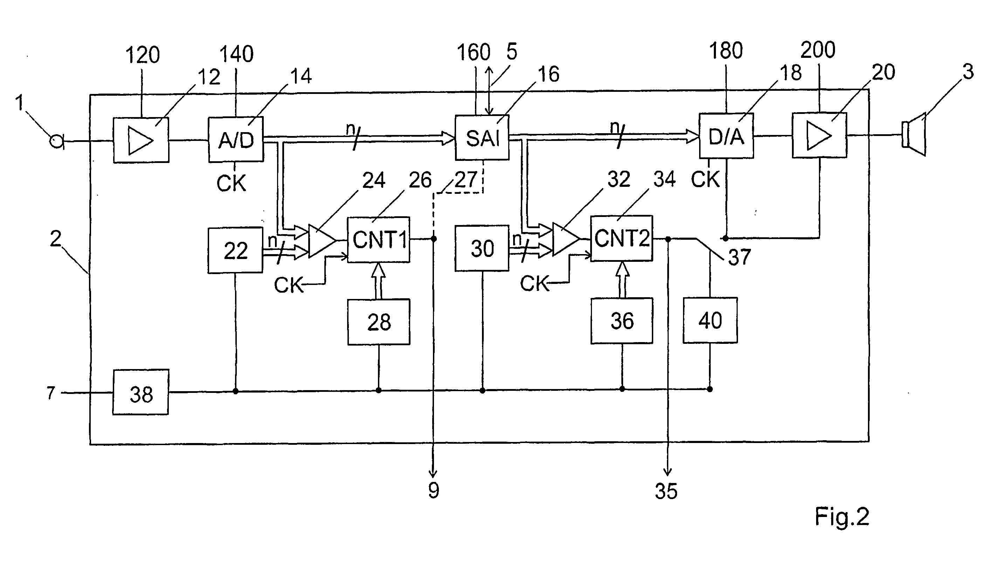

Le codec 2 est illustré de manière plus détaillée sur la figure 2. Le signal analogique fourni par exemple par le microphone 1 est amplifié par un étage d'amplification 12 puis converti en une séquence d'échantillons numériques à n bits par un convertisseur analogique-numérique conventionnel 14. Un signal d'horloge CK fourni par un circuit d'horloge non représenté détermine les instants d'échantillonnage du convertisseur 14. Les n bits de chaque échantillon sont fournis en parallèle, à chaque instant d'échantillonnage, à une interface audio sérielle 16 qui les convertit en un signal sériel sur une ligne 5 externe selon un protocole prédéfini, par exemple selon le protocole IIS. Le fonctionnement de l'interface audio sérielle 16 ainsi que les paramètres de transmission sérielle peuvent être définis au moyen de registres non représentés accessibles depuis l'extérieur du circuit 2.

Selon l'invention, le codec 2 comprend en outre un premier comparateur 24 pour comparer les échantillons numériques délivrés par le convertisseur 14 avec une première valeur de seuil TH1 mémorisée dans un premier registre 22. Un premier compteur 26 est incrémenté à chaque fois que la sortie du comparateur 24 est active, c'est-à-dire lorsque l'échantillon numérique est inférieur à la valeur de seuil TH1 prédéterminée dans le registre 22. La sortie 9 du premier compteur 26 est un signal de mode de veille qui est actif lorsque la valeur comptée est supérieure à une deuxième valeur de seuil TH2 mémorisée dans un deuxième registre 28. Le compteur 26 est remis à zéro (ou réinitialisé à une autre valeur prédéfinie) à la mise sous tension du codec 2 et lorsque la sortie du comparateur 24 est inactive, c'est-à-dire lorsque le signal d'entrée est supérieur à TH1. Le signal 9 à la sortie du compteur 26 est donc à un niveau inactif à la mise sous tension du système et passe au niveau actif lorsque TH2 échantillons numériques consécutifs sont inférieurs à la valeur de seuil TH1. Le signal 9 permet ainsi d'indiquer la présence ou l'absence de voix dans le signal analogique reçu du microphone et peut être utilisé hors du codec 2 pour mettre en mode de veille d'autres composants du système, par exemple le processeur 4 et/ou le module de communication 6, dès que le signal analogique d'entrée est inférieur pendant TH2 intervalles au seuil TH1. Comme indiqué par la ligne traitillée 27, il est aussi possible dans une variante de l'invention de désactiver automatiquement l'interface audio sérielle 16 lorsque le signal de mode de veille 9 est à l'état actif.

Dans une variante préférentielle de l'invention, le signal de mode de veille 9 est connecté directement avec une ligne d'interruption du microprocesseur 4. Une routine logicielle exécutée par le microprocesseur 4 détecte toute modification de l'état logique de la ligne d'interruption et réagit lorsque celle-ci est à un niveau actif en mettant tout ou partie du microprocesseur 4, ainsi que de préférence d'autres composants du système, par exemple le module de communication 6 ou certains éléments du codec 2, en mode de veille. Il est cependant aussi possible d'interrompre directement l'alimentation d'un ou plusieurs composants 4, 6 lorsque le signal de mode de veille 9 est actif, au risque toutefois d'interrompre brutalement certaines routines exécutées par le processeur.

Le codec 2 comprend en outre un circuit de conversion numérique-analogique pour convertir une séquence de données numériques reçue sur l'interface sérielle 5 en un signal analogique apte à commander par exemple un haut-parleur 3. Le signal numérique série, par exemple au format IIS, est converti par l'interface sérielle audio 16 en une séquence de mots de n bits fournie à un convertisseur numérique-analogique 18. La sortie analogique du convertisseur 18 est amplifiée et éventuellement filtrée par un amplificateur 20 permettant d'attaquer le haut-parleur 3. Le gain de l'amplificateur 20 peut de préférence être contrôlé au moyen d'un registre non représenté accessible depuis l'extérieur du codec 2.

Selon l'invention, le codec 2 comprend en outre un deuxième comparateur 32 pour comparer les mots de n bits fournis par l'interface 16 avec une troisième valeur de seuil TH3 mémorisée dans un troisième registre 30. Un deuxième compteur 34 est incrémenté à chaque fois que la sortie du comparateur 32 est active, c'est-à-dire lorsque le mot numérique reçu est inférieur à la valeur de seuil TH3 prédéterminée dans le registre 30. La sortie 35 du deuxième compteur 34 est active lorsque la valeur dans le compteur est supérieure à une quatrième valeur de seuil TH4 mémorisée dans un quatrième registre 36. Le compteur 34 est remis à zéro (ou réinitialisé à une autre valeur prédéfinie) à la mise sous tension du codec 2 et lorsque la sortie du comparateur 32 est inactive, c'est-à-dire lorsque le mot reçu est supérieur à TH3. Le signal 35 à la sortie du compteur 34 est un deuxième signal de mode de veille qui est à un niveau inactif à la mise sous tension du système et passe au niveau actif lorsque le mot reçu est, pendant TH4 instants d'échantillonnage consécutifs, inférieur à la valeur de seuil TH3. Ce signal permet donc d'indiquer la présence ou l'absence de voix dans le signal numérique reçu et peut être utilisé hors du codec 2 pour mettre en mode de veille d'autres composants du système, par exemple le processeur 4 et/ou le module de communication 6, dès que le signal numérique d'entrée est inférieur pendant TH4 intervalles au seuil TH3. Selon l'invention, ce signal 35 peut aussi être utilisé pour désactiver directement les composants du codec en aval de l'interface 16, en particulier le convertisseur numérique-analogique 18 et l'amplificateur 20. Un interrupteur 37 commandé par un registre ou une bascule 40 accessible depuis l'extérieur du circuit 2 permet d'interrompre la connexion directe du signal 35 aux composants 18, 20, et d'empêcher ou d'autoriser la mise en mode de veille automatique de ces composants par le compteur 34.

Le contenu des registres 22, 28, 30, 36 et 40 définissant les valeurs de seuil mentionnées, ainsi que d'autres registres permettant par exemple de paramétrer le fonctionnement de l'interface audio sérielle 16 ou le gain des amplificateurs 12, 20, peut être modifié depuis l'extérieur du circuit 2 au travers d'un contrôleur d'interface sériel 38. Le processeur 4 peut ainsi ajuster les seuils des comparateurs 22, 32 et des compteurs 26, 34 en communiquant au travers de la ligne sérielle 7 avec le contrôleur 38.

Au moins certains composants du codec 2 peuvent de préférence être mis en mode de veille par le microcontrôleur 4, indépendamment des valeurs dans les compteurs 26 et 36. On prévoira ainsi de préférence la possibilité de désactiver l'amplificateur 12, le convertisseur A/N 14, l'interface sérielle audio 16, le convertisseur N/A 18 et/ou l'amplificateur 20, indépendamment les uns des autres. Chaque composant 12, 14, 16, 18, respectivement 20 peut par exemple être mis en mode de veille en agissant directement sur une broche externe 120, 140, 160, 180, respectivement 200. Cela permet à l'utilisateur du codec 2 de reboucler les signaux de mode de veille 9, 36 générés par le codec sur une ou plusieurs des broches 120 à 200, afin par exemple de mettre l'interface sérielle audio 16 automatiquement en mode de veille lorsque le signal 9 est actif. Il est aussi possible de prévoir un ou plusieurs registres non représentés pour définir au travers du contrôleur d'interface sériel 38 quels composants doivent être placés en mode de veille. Cette variante permet de limiter le nombre de broches externe, mais ne permet pas de contrôler par câblage la mise en mode de veille des composants du codec.

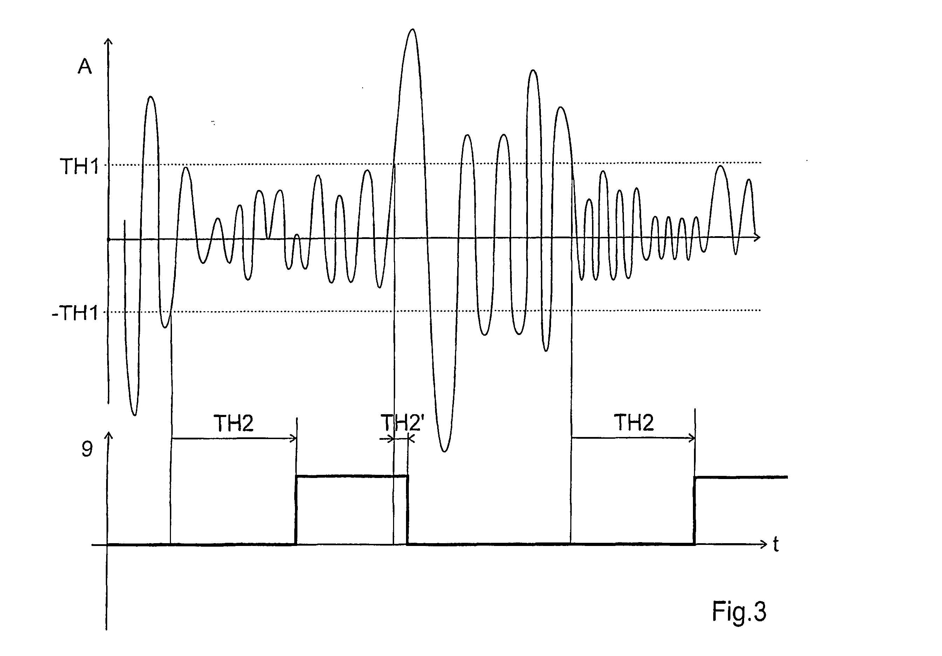

La figure 3 illustre de manière schématique la forme du premier signal de mode de veille 9 généré par le codec 2 lorsque le signal analogique dont l'amplitude A est représentée sur la partie supérieure du chronogramme est appliqué à l'entrée de l'amplificateur 12. A la mise sous tension du codec, le compteur 26 est réinitialisé en sorte que le signal 9 est à l'état inactif, représenté ici par l'état logique 0. Le compteur 26 est incrémenté à chaque instant d'échantillonnage lorsque le signal numérisé est, en valeur absolue, inférieur à la valeur de seuil TH1 dans le premier registre 22, et réinitialisé lorsque le signal numérisé est supérieur à TH1. Le signal 9 à la sortie du compteur 26 devient actif (représenté ici par l'état logique 1) dès que la valeur dans le compteur est supérieure à la valeur de seuil TH2 dans le registre 28. En d'autres termes, le mode de veille 9 est activé lorsque le signal d'entrée numérisé est inférieur à TH1 pendant TH2 intervalles d'échantillonnage consécutifs.

Le compteur 26 et le signal de mode de veille 9 sont réinitialisés dès que le signal d'entrée est à nouveau supérieur à TH1 (en valeur absolue). Afin d'éviter l'influence de bruits parasites, il est aussi possible, comme illustré sur la figure 3, de prévoir un délai TH2', de préférence inférieur à TH2, avant de remettre à zéro le compteur 26. En d'autres termes, le mode de veille n'est désactivé que si au moins TH2' échantillons successifs sont supérieurs en valeur absolue à la valeur de seuil TH1. La valeur TH2' peut également être mémorisée dans un registre non représenté sur la figure 2; les modifications nécessaires au codec sont à la portée de l'homme du métier.

Dans une variante, il est aussi possible de prévoir deux valeurs du seuil TH1 différentes pour l'activation et la désactivation du mode de veille 9. Cette variante peut par exemple être mise en oeuvre en employant un comparateur 24 avec une hystérésis ("comparateur de Schmitt").

On comprendra que des dispositions similaires peuvent être appliquées au circuit de mode de veille générant le deuxième signal de mode de veille 35 à partir des valeurs successives du signal numérique 5. En particulier, il est possible de prévoir au moyen d'éléments logiques non représentés un délai TH4' pour la réinitialisation du compteur 34, et des valeurs de seuil TH3 différentes pour l'activation et la désactivation du mode de veille 9 (hystérésis).

Les signaux de mode de veille 9 et 35 sont dans l'exemple décrit ci-dessus activés uniquement lorsqu'un nombre prédéfini d'échantillons numériques successifs est inférieur à une valeur de seuil déterminée. Il est cependant possible dans le cadre de cette invention de générer ces signaux à partir d'autres caractéristiques du signal numérique, par exemple en calculant l'énergie, ou la variation d'énergie, ou la puissance, ou la dérivée, et/ou l'intégrale du signal numérique. Il est ainsi possible, au prix d'une complexité accrue du système, de détecter plus rapidement et avec une meilleure fiabilité la présence ou l'absence de données significatives dans la séquence numérique convertie ou reçue. Par ailleurs, un filtrage analogique et/ou numérique peut être effectué dans le codec pour réduire l'influence du bruit.

Le processeur 4 peut comprendre une routine informatique qui surveille l'état des deux signaux de mode de veille 9, 35 pour activer ou désactiver sélectivement certains composants du système. Dans une application de téléphonie où, généralement, un seul partenaire parle à la fois, il est ainsi possible de désactiver presque à chaque instant soit le circuit d'acquisition, soit le circuit de restitution, et de réduire ainsi considérablement la consommation électrique du circuit.

## Revendications

1. Convertisseur analogique-numérique réalisé sous la forme d'un composant électronique, comportant:
un circuit de conversion analogique-numérique (14) pour convertir un signal analogique d'entrée en une séquence d'échantillons numériques,
un étage de sortie (16) pour fournir ladite séquence hors dudit composant (2),
un premier circuit (22, 24,26, 28) de détection de signal pour générer un signal de mode de veille (9)
**caractérisé en ce que** ledit composant électronique est un composant électronique discret (2),
**en ce que** ledit étage de sortie est agencé pour fournir ladite séquence sous forme sérielle hors dudit composant (2),
**en ce que** ledit signal de mode de veille (9) est connecté à une broche de sortie dudit composant électronique discret (2) pour indiquer hors dudit composant discret (2) la présence ou l'absence de données significatives dans ladite séquence,
et **en ce que** ledit étage de sortie (16) est mis en mode de veille en l'absence de données significatives dans ladite séquence.

2. Convertisseur selon la revendication précédente, dans lequel ledit premier circuit de détection de signal comporte un premier comparateur (24) pour comparer lesdits échantillons numériques avec une première valeur de seuil prédéfinie (TH1).

3. Convertisseur selon la revendication précédente, dans lequel ladite première valeur de seuil (TH1) est mémorisée dans un premier registre (22) accessible en écriture depuis l'extérieur dudit composant (2).

4. Convertisseur selon l'une des revendications 2 ou 3, dans lequel ledit premier comparateur (24) est un comparateur à hystérésis.

5. Convertisseur selon l'une des revendications 2 à 4, dans lequel ledit circuit de détection de signal comporte un premier compteur (26) dont la valeur est incrémentée à chaque fois qu'un échantillon numérique est inférieure en valeur absolue à ladite première valeur de seuil (TH1),
une indication d'absence de signal étant générée lorsque la valeur dans ledit premier compteur atteint un deuxième valeur de seuil prédéfinie (TH2).

6. Convertisseur selon la revendication précédente, dans lequel ladite deuxième valeur de seuil (TH2) est mémorisée dans un deuxième registre (28) accessible en écriture depuis l'extérieur dudit composant (2).

7. Convertisseur selon l'une des revendications 5 ou 6, dans lequel ledit premier compteur (26) est réinitialisé à chaque fois qu'un échantillon est supérieur en valeur absolue à ladite première valeur de seuil (TH1).

8. Convertisseur selon la revendication précédente, dans lequel ledit premier compteur (26) est réinitialisé à chaque fois qu'un nombre prédéfini (TH2') d'échantillons successifs sont supérieurs en valeur absolue à ladite première valeur de seuil (TH1).

9. Convertisseur selon l'une des revendications 5 ou 6, dans lequel ladite valeur dans ledit premier compteur (26) est décrémentée à chaque fois qu'une donnée fournie par ledit convertisseur analogique-numérique est supérieure à ladite première valeur de seuil.

10. Convertisseur selon l'une des revendications précédentes, comprenant en outre:
un circuit de conversion numérique-analogique (18) pour convertir une séquence d'entrée numérique en un signal analogique,
un étage de sortie (20) pour fournir hors dudit composant (2) ledit signal analogique,
**caractérisé par** un deuxième circuit (30, 32, 34, 36) de détection de signal pour générer un deuxième signal de mode de veille (35) connecté à une broche de sortie dudit composant électronique discret (2) pour indiquer hors dudit composant la présence ou l'absence de signal significatif dans ladite séquence et en ce que ledit étage de sortie (20) et/ou ledit circuit de conversion numérique-analogique (18) sont mis en mode de veille en l'absence de données significatives dans ladite séquence numérique d'entrée.

11. Convertisseur selon la revendication précédente, dans lequel ledit deuxième circuit de détection de signal comporte un deuxième comparateur (32) pour comparer ladite séquence d'entrée avec une troisième valeur de seuil (TH3) prédéfinie.

12. Convertisseur selon la revendication précédente, dans lequel ladite troisième valeur de seuil (TH3) est mémorisée dans un troisième registre (30) accessible en écriture depuis l'extérieur dudit composant (2).

13. Convertisseur selon l'une des revendications 11 ou 12, dans lequel ledit deuxième comparateur (32) est un comparateur à hystérésis.

14. Convertisseur selon l'une des revendications 11 à 13, dans lequel ledit circuit de détection de signal comporte un deuxième compteur (34) dont la valeur est incrémentée à chaque fois qu'une donnée dans ladite séquence d'entrée numérique est inférieure à ladite troisième valeur de seuil (TH3),
une indication d'absence de signal étant générée lorsque la valeur dans ledit deuxième compteur (34) atteint une quatrième valeur de seuil (TH4) prédéfinie.

15. Convertisseur selon la revendication précédente, dans lequel ladite quatrième valeur de seuil (TH4) est mémorisée dans un quatrième registre (36) accessible en écriture depuis l'extérieur dudit composant.

16. Convertisseur selon l'une des revendications 14 ou 15, dans lequel ledit deuxième compteur (34) est réinitialisé à chaque fois qu'une donnée dans ladite séquence numérique d'entrée est supérieure à ladite troisième valeur de seuil (TH3).

17. Convertisseur selon la revendication précédente, dans lequel ledit deuxième compteur (34) est réinitialisé à chaque fois qu'un nombre prédéfini d'échantillons successifs sont supérieurs en valeur absolue à ladite troisième valeur de seuil (TH3).

18. Convertisseur selon l'une des revendications 14 ou 15, dans lequel ladite valeur dans ledit deuxième compteur (34) est décrémentée à chaque fois qu'une donnée dans ladite séquence numérique d'entrée est supérieure à ladite troisième valeur de seuil (TH3).

19. Convertisseur numérique-analogique réalisé sous la forme d'un composant électronique discret (2), comportant:
un circuit de conversion numérique-analogique (18) pour convertir une séquence d'entrée numérique en un signal analogique,
un étage de sortie (20) pour fournir hors dudit composant (2) ledit signal analogique,
**caractérisé par** un deuxième circuit (30, 32, 34, 36) de détection de signal pour générer un deuxième signal de mode de veille (35) connecté à une broche de sortie dudit composant électronique discret (2) pour indiquer hors dudit composant la présence ou l'absence de signal significatif dans ladite séquence et en ce que ledit étage de sortie (20) et/ou ledit circuit de conversion numérique-analogique (18) sont mis en mode de veille en l'absence de données significatives dans ladite séquence numérique d'entrée.

20. Convertisseur selon la revendication précédente, dans lequel ledit deuxième circuit de détection de signal comporte un deuxième comparateur (32) pour comparer ladite séquence d'entrée avec une troisième valeur de seuil (TH3) prédéfinie.

21. Convertisseur selon la revendication précédente, dans lequel ladite troisième valeur de seuil (TH3) est mémorisée dans un troisième registre (30) accessible en écriture depuis l'extérieur dudit composant (2).

22. Convertisseur selon l'une des revendications 20 ou 21, dans lequel ledit deuxième comparateur (32) est un comparateur à hystérésis.

23. Convertisseur selon l'une des revendications 20 à 22, dans lequel ledit circuit de détection de signal comporte un deuxième compteur (34) dont la valeur est incrémentée à chaque fois qu'une donnée dans ladite séquence d'entrée numérique est inférieure à ladite troisième valeur de seuil (TH3),
une indication d'absence de signal étant générée lorsque la valeur dans ledit deuxième compteur (34) atteint une quatrième valeur de seuil (TH4) prédéfinie.

24. Convertisseur selon la revendication précédente, dans lequel ladite quatrième valeur de seuil (TH4) est mémorisée dans un quatrième registre (36) accessible en écriture depuis l'extérieur dudit composant.

25. Convertisseur selon l'une des revendications 23 ou 24, dans lequel ledit deuxième compteur est réinitialisé à chaque fois qu'une donnée dans ladite séquence numérique d'entrée est supérieure à ladite troisième valeur de seuil.

26. Convertisseur selon la revendication précédente, dans lequel ledit deuxième compteur (34) est réinitialisé à chaque fois qu'un nombre prédéfini d'échantillons successifs (TH4') sont supérieurs en valeur absolue à ladite troisième valeur de seuil (TH3).

27. Convertisseur selon l'une des revendications 23 ou 24, dans lequel ladite valeur dans ledit deuxième compteur est décrémentée à chaque fois qu'une donnée numérique d'entrée est supérieure à ladite deuxième valeur de seuil.

28. Convertisseur selon l'une des revendications 19 à 27, dans lequel au moins ledit circuit de conversion numérique-analogique (18) est mis en mode de veille en l'absence de données significatives dans ladite séquence numérique d'entrée.

29. Convertisseur selon l'une des revendications 19 à 28, ledit étage de sortie (20) étant mis en mode de veille en l'absence de données significatives dans ladite séquence numérique d'entrée.

30. Système d'acquisition, de traitement et de restitution de données audio, comprenant
un convertisseur analogique-numérique et numérique analogique (2) selon l'une des revendications 10 à 18,
un processeur de traitement de signal (4) pour traiter la séquence d'échantillons numériques fournie au ou reçue dudit convertisseur,
dans lequel ledit processeur (4) est mis en mode de veille lorsque un signal de mode de veille (9, 35) généré par ledit convertisseur (2) indique une absence de données significatives dans ladite séquence.

31. Système d'acquisition selon la revendication précédente, dans lequel ledit convertisseur (2) comprend au moins une broche de sortie pour un signal de mode de veille, ladite broche de sortie étant reliée électriquement à une entrée d'interruption matérielle dudit processeur (4), ledit processeur comprenant un module informatique apte à être exécuté par ledit processeur pour détecter toute modification de l'état logique de la ligne d'interruption et réagir lorsque celle-ci est à un niveau actif en mettant tout ou partie dudit système en mode de veille.

## Patentansprüche

1. Analog-Digital-Umsetzer, ausgeführt in der Form einer elektronischen Komponente, umfassend:
eine Analog-Digital-Umsetzungsschaltung (14) für das Umsetzen eines Analog-Eingangssignals in eine Sequenz von digitalen Abtastwerten,
eine Ausgangsstufe (16) für das Liefern der besagten Sequenz ausserhalb der besagten Komponente (2),
eine erste Signalerkennungsschaltung (22, 24, 26, 28) für das Erzeugen eines Standby-Modussignals (9),
**dadurch gekennzeichnet, dass** besagte elektronische Komponente eine diskrete elektronische Komponente (2) ist,
dass besagte Ausgangsstufe so angeordnet ist, um besagte Sequenz in serieller Form ausserhalb der besagten Komponente (2) zu liefern,
dass besagtes Standby-Modussignal (9) mit einem Ausgangsstift der besagten diskreten elektronischen Komponente (2) verbunden ist, um ausserhalb der besagten diskreten Komponente (2) das Vorhandensein oder das Fehlen von signifikativen Daten in besagter Sequenz anzugeben,
und dass besagte Ausgangsstufe (16) bei Fehlen von signifikativen Daten in besagter Sequenz in Standby-Modus gesetzt wird.

2. Umsetzer gemäss dem vorhergehenden Anspruch, worin besagte erste Signalerkennungsschaltung einen ersten Komparator (24) umfasst, um besagte digitalen Abtastwerten mit einem ersten vorbestimmten Grenzwert (TH1) zu vergleichen.

3. Umsetzer gemäss dem vorhergehenden Anspruch, worin der besagte erste Grenzwert (TH1) in einem ersten Register (22) gespeichert wird, welches von ausserhalb der besagten Komponente (2) zum Schreiben zugänglich ist.

4. Umsetzer gemäss einem der Ansprüche 2 oder 3, worin der besagte erste Komparator (24) ein Hysteresekomparator ist.

5. Umsetzer gemäss einem der Ansprüche 2 bis 4, worin besagte Signalerkennungsschaltung einen ersten Zähler (26) umfasst, dessen Wert jedesmal inkrementiert wird, wenn ein digitaler Abtastwert im Absolutwert tiefer als der besagte erste Grenzwert (TH1) liegt,
wobei eine Angabe über das Fehlen eines Signals erzeugt wird, wenn der Wert im besagten ersten Zähler einen zweiten vorbestimmten Grenzwert (TH2) erreicht.

6. Umsetzer gemäss dem vorhergehenden Anspruch, worin der besagte zweite Grenzwert (TH2) in einem zweiten Register (28) gespeichert wird, welches von ausserhalb der besagten Komponente (2) zum Schreiben zugänglich ist.

7. Umsetzer gemäss einem der Ansprüche 5 oder 6, worin der besagte erste Zähler (26) jedesmal neu initialisiert wird, wenn ein Abtastwert im Absolutwert höher als der besagte erste Grenzwert (TH1) liegt.

8. Umsetzer gemäss dem vorhergehenden Anspruch, worin der besagte erste Zähler (26) jedesmal neu initialisiert wird, wenn eine vorbestimmte Anzahl (TH2') von sukzessiven Abtastwerten im Absolutwert höher als der besagte erste Grenzwert (TH1) liegen.

9. Umsetzer gemäss einem der Ansprüche 5 oder 6, worin besagter Wert im besagten ersten Zähler (26) jedesmal dekrementiert wird, wenn eine vom Analog-Digital-Umsetzer gelieferte Dateneinheit höher als der besagte erste Grenzwert liegt.

10. Umsetzer gemäss einem der vorhergehenden Ansprüche, ferner umfassend:
eine Digital-Analog-Umsetzungsschaltung (18) für das Umsetzen einer Digital-Eingangssequenz in ein Analogsignal,
eine Ausgangsstufe (20) für das Liefern des besagten Analogsignals ausserhalb der besagten Komponente (2),
**gekennzeichnet durch** eine zweite Signalerkennungsschaltung (30, 32, 34, 36) für das Erzeugen eines zweiten Standby-Modussignals (35), verbunden mit einem Ausgangsstift der besagten diskreten elektronischen Komponente (2), um ausserhalb besagter Komponente das Vorhandensein oder das Fehlen eines signifikativen Signals in besagter Sequenz anzugeben, und dass besagte Ausgangsstufe (20) und/oder besagte Digital-Analog-Umsetzungsschaltung (18) bei Fehlen von signifikativen Daten in besagter Digital-Eingangssequenz in Standby-Modus gesetzt werden.

11. Umsetzer gemäss dem vorhergehenden Anspruch, worin besagte zweite Signalerkennungsschaltung einen zweiten Komparator (32) umfasst, um besagte Eingangssequenz mit einem dritten vorbestimmten Grenzwert (TH3) zu vergleichen.

12. Umsetzer gemäss dem vorhergehenden Anspruch, worin der besagte dritte Grenzwert (TH3) in einem dritten Register (30) gespeichert wird, welches von ausserhalb der besagten Komponente (2) zum Schreiben zugänglich ist.

13. Umsetzer gemäss einem der Ansprüche 11 oder 12, worin der besagte zweite Komparator (32) ein Hysteresekomparator ist.

14. Umsetzer gemäss einem der Ansprüche 11 bis 13, worin besagte Signalerkennungsschaltung einen zweiten Zähler (34) umfasst, dessen Wert jedesmal inkrementiert wird, wenn eine Dateneinheit in der besagten Digital-Eingangssequenz tiefer als der besagte dritte Grenzwert (TH3) liegt,
wobei eine Angabe über das Fehlen eines Signals erzeugt wird, wenn der Wert im besagten zweiten Zähler (34) einen vierten vorbestimmten Grenzwert (TH4) erreicht.

15. Umsetzer gemäss dem vorhergehenden Anspruch, worin der besagte vierte Grenzwert (TH4) in einem vierten Register (36) gespeichert wird, welches von ausserhalb der besagten Komponente (2) zum Schreiben zugänglich ist.

16. Umsetzer gemäss einem der Ansprüche 14 oder 15, worin der besagte zweite Zähler (34) jedesmal neu initialisiert wird, wenn eine Dateneinheit in besagter Digital-Eingangssequenz höher als der besagte dritte Grenzwert (TH3) liegt.

17. Umsetzer gemäss dem vorhergehenden Anspruch, worin der besagte zweite Zähler (34) jedesmal neu initialisiert wird, wenn eine vorbestimmte Anzahl von sukzessiven Abtastwerten im Absolutwert höher als der besagte dritte Grenzwert (TH3) liegen.

18. Umsetzer gemäss einem der Ansprüche 14 oder 15, worin besagter Wert im besagten zweiten Zähler (34) jedesmal dekrementiert wird, wenn eine Dateneinheit in besagter Digital-Eingangssequenz höher als der besagte dritte Grenzwert (TH3) liegt.

19. Digital-Analog-Umsetzer, ausgeführt in der Form einer diskreten elektronischen Komponente (2), umfassend:
eine Digital-Analog-Umsetzungsschaltung (18) für das Umsetzen einer Digital-Eingangssequenz in ein Analogsignal,
eine Ausgangsstufe (20) für das Liefern des besagten Analogsignals ausserhalb der besagten Komponente (2),
**gekennzeichnet durch** eine zweite Signalerkennungsschaltung (30, 32, 34, 36) für das Erzeugen eines zweiten Standby-Modussignals (35), verbunden mit einem Ausgangsstift der besagten diskreten elektronischen Komponente (2), um ausserhalb besagter Komponente das Vorhandensein oder das Fehlen eines signifikativen Signals in besagter Sequenz anzugeben, und dass besagte Ausgangsstufe (20) und/oder besagte Digital-Analog-Umsetzungsschaltung (18) bei Fehlen von signifikativen Daten in besagter Digital-Eingangssequenz in Standby-Modus gesetzt werden.

20. Umsetzer gemäss dem vorhergehenden Anspruch, worin besagte zweite Signalerkennungsschaltung einen zweiten Komparator (32) umfasst, um besagte Eingangssequenz mit einem dritten vorbestimmten Grenzwert (TH3) zu vergleichen.

21. Umsetzer gemäss dem vorhergehenden Anspruch, worin der besagte dritte Grenzwert (TH3) in einem dritten Register (30) gespeichert wird, welches von ausserhalb der besagten Komponente (2) zum Schreieben zugänglich ist.

22. Umsetzer gemäss einem der Ansprüche 20 oder 21, worin der besagte zweite Komparator (32) ein Hysteresekomparator ist.

23. Umsetzer gemäss einem der Ansprüche 20 bis 22, worin besagte Signalerkennungsschaltung einen zweiten Zähler (34) umfasst, dessen Wert jedesmal inkrementiert wird, wenn eine Dateneinheit in der besagten Digital-Eingangssequenz tiefer als der besagte dritte Grenzwert (TH3) liegt,
wobei eine Angabe über das Fehlen eines Signals erzeugt wird, wenn der Wert im besagten zweiten Zähler (34) einen vierten vorbestimmten Grenzwert (TH4) erreicht.

24. Umsetzer gemäss dem vorhergehenden Anspruch, worin der besagte vierte Grenzwert (TH4) in einem vierten Register (36) gespeichert wird, welches von ausserhalb der besagten Komponente (2) zum Schreiben zugänglich ist.

25. Umsetzer gemäss einem der Ansprüche 23 oder 24, worin der besagte zweite Zähler jedesmal neu initialisiert wird, wenn eine Dateneinheit in besagter Digital-Eingangssequenz höher als der besagte dritte Grenzwert liegt.

26. Umsetzer gemäss dem vorhergehenden Anspruch, worin der besagte zweite Zähler (34) jedesmal neu initialisiert wird, wenn eine vorbestimmte Anzahl von sukzessiven Abtastwerten (TH4') im Absolutwert höher als der besagte dritte Grenzwert (TH3) liegen.

27. Umsetzer gemäss einem der Ansprüche 23 oder 24, worin besagter Wert im besagten zweiten Zähler jedesmal dekrementiert wird, wenn eine Digital-Eingangsdateneinheit höher als der besagte zweite Grenzwert liegt.

28. Umsetzer gemäss einem der Ansprüche 19 bis 27, worin besagte Digital-Analog-Umsetzungsschaltung (18) bei Fehlen von signifikativen Daten in besagter Digital-Eingangssequenz in Standby-Modus gesetzt wird.

29. Umsetzer gemäss einem der Ansprüche 19 bis 28, wobei besagte Ausgangsstufe (20) bei Fehlen von signifikativen Daten in besagter Digital-Eingangssequenz in Standby-Modus gesetzt wird.

30. System für die Erfassung, Verarbeitung und Wiedergabe von Audiodaten, umfassend:
einen Analog-Digital- und Digital-Analog-Umsezter (2) gemäss einem der Ansprüche 10 bis 18,
einen Signalverarbeitungsprozessor (4) für die Verarbeitung der an den besagten Umsetzer gelieferten oder vom besagten Umsetzer erhaltenen Digitalabtastwertensequenz,
worin besagter Prozessor (4) in Standby-Modus gesetzt wird, wenn ein vom besagten Umsetzer (2) erzeugtes Standby-Modussignal (9, 35) das Fehlen von signifikativen Daten in besagter Sequenz angibt.

31. Erfassungssystem gemäss dem vorhergehenden Anspruch, worin besagter Umsetzer (2) mindestens einen Ausgangsstift für ein Standby-Modussignal umfasst, wobei besagter Ausgangsstift mit einem materiellen Unterbrechungseingang des besagten Prozessors (4) elektrisch verbunden ist, wobei besagter Prozessor ein Rechnungsmodul umfasst, das vom besagten Prozessor ausgeführt werden kann, um jede Änderung des logischen Zustandes der Unterbrechungsleitung zu erkennen und zu reagieren, wenn Letztere auf einem aktiven Niveau ist, indem das besagte System ganz oder teilweise in Standby-Modus gesetzt wird.

## Claims

1. Analog-to-digital converter made in the form of an electronic component, comprising:
an analog-to-digital conversion circuit (14) for converting an analog input signal into a sequence of digital samples,
an output stage (16) for supplying said sequence outside said component (2),
a first signal detection circuit (22, 24, 26, 28) for generating a standby-mode signal (9),
**characterized in that** said electronic component is a discrete electronic component (2),
**in that** said output stage is arranged to supply said sequence in serial form outside said component (2),
**in that** said standby-mode signal (9) is connected to an output pin of said discrete electronic component (2) for indicating outside said discrete component (2) the presence or absence of significant data in said sequence,
and **in that** said output stage (16) is put in standby mode in the absence of significant data in said sequence.

2. Converter according to the preceding claim, wherein said first signal detection circuit comprises a first comparator (24) for comparing said digital samples with a first predefined threshold value (TH1).

3. Converter according to the preceding claim, wherein said first threshold value (TH1) is stored in a first register (22) accessible in writing from outside said component (2).

4. Converter according to one of the claims 2 or 3, wherein said first comparator (24) is a hysteresis comparator.

5. Converter according to one of the claims 2 to 4, wherein said signal detection circuit comprises a first counter (26) whose value is incremented each time a digital sample is lower in absolute value than said first threshold value (TH1),
an indication of absence of signal being generated when the value in said first counter reaches a second predefined threshold value (TH2).

6. Converter according to the preceding claim, wherein said second threshold value (TH2) is stored in a second register (28) accessible in writing from outside said component (2).

7. Converter according to one of the claims 5 or 6, wherein said first counter (26) is reinitialized each time a sample is greater in absolute value than said first threshold value (TH1).

8. Converter according to the preceding claim, wherein said first counter (26) is reinitialized each time a predefined number (TH2') of successive samples is greater in absolute value than said first threshold value (TH1).

9. Converter according to one of the claims 5 or 6, wherein said value in said first counter (26) is decremented each time a data supplied by said analog-to-digital converter is greater than said first threshold value.

10. Converter according to one of the preceding claims, further comprising:
a digital-to-analog conversion circuit (18) for converting a digital input sequence into an analog signal,
an output stage (20) for supplying outside said component (2) said analog signal,
**characterized by** a second signal detection circuit (30, 32, 34, 36) for generating a second standby-mode signal (35) connected with an output pin of said discrete electronic component (2) indicating outside said component the presence or absence of significant signal in said sequence and in that said output stage (20) and/or said digital-to-analog conversion circuit (18) are put in standby mode in the absence of significant data in said digital input sequence.

11. Converter according to the preceding claim, wherein said second signal detection circuit comprises a second comparator (32) for comparing said input sequence with a third predefined threshold value (TH3).

12. Converter according to the preceding claim, wherein said third threshold value (TH3) is stored in a third register (30) accessible in writing from outside said component (2).

13. Converter according to one of the claims 11 or 12, wherein said second comparator (32) is a hysteresis comparator.

14. Converter according to one of the claims 11 to 13, wherein said signal detection circuit comprises a second counter (34) whose value is incremented each time a data in said digital input sequence is lower than said third threshold value (TH3),
an indication of absence of signal being generated when the value in said second counter (34) reaches a fourth predefined threshold (TH4).

15. Converter according to the preceding claim, wherein said fourth threshold value (TH4) is stored in a fourth register (36) accessible in writing from outside said component.

16. Converter according to one of the claims 14 or 15, wherein said second counter (34) is reinitialized each time a data in said digital input sequence is greater than said third threshold value (TH3).

17. Converter according to the preceding claim, wherein said second counter (34) is reinitialized each time a predefined number of successive samples is greater in absolute value than said third threshold value (TH3).

18. Converter according to one of the claims 14 or 15, wherein said value in said second counter (34) is decremented each time a data in said digital input sequence is greater than said third threshold value (TH3).

19. Digital-to-analog converter made in the form of a discrete electronic component (2), comprising:
a digital-to-analog conversion circuit (18) for converting a digital input sequence into an analog signal,
an output stage (20) for supplying said analog sequence outside said component (2),
**characterized by** a second signal detection circuit (30, 32, 34, 36) for generating a second standby-mode signal (35) connected to an output pin of said discrete electronic component (2) for indicating outside said component the presence or absence of significant data in said sequence and in that said output stage (20) and/or said digital-to-analog conversion circuit (18) are put in standby mode in the absence of significant data in said digital input sequence.

20. Converter according to the preceding claim, wherein said second signal detection circuit comprises a second comparator (32) for comparing said input sequence with a third predefined threshold value (TH3).

21. Converter according to the preceding claim, wherein said third threshold value (TH3) is stored in a third register (30) accessible in writing from outside said component (2).

22. Converter according to one of the claims 20 or 21, wherein said second comparator (32) is a hysteresis comparator.

23. Converter according to one of the claims 20 to 22, wherein said signal detection circuit comprises a second counter (34) whose value is incremented each time a data in said digital input sequence is lower than said third threshold value (TH3),
an indication of absence of signal being generated when the value in said second counter (34) reaches a fourth predefined threshold value (TH4).

24. Converter according to the preceding claim, wherein said fourth threshold value (TH4) is stored in a fourth register (36) accessible in writing from outside said component.

25. Converter according to one of the claims 23 or 24, wherein said second counter is reinitialized each time a data in said digital input sequence is greater than said third threshold value.

26. Converter according to the preceding claim, wherein said second counter (34) is reinitialized each time a predefined number of successive samples (TH4') is greater in absolute value than said third threshold value (TH3).

27. Converter according to one of the claims 23 or 24, wherein said value in said second counter is decremented each time a digital input data is greater than said second threshold value.

28. Converter according to one of the claims 19 to 27, wherein at least said digital-to-analog conversion circuit (18) is put in standby mode in the absence of significant data in said digital input sequence.

29. Converter according to one of the claims 19 to 28, said output stage (20) being put in standby mode in the absence of significant data in said digital input sequence.

30. Acquisition, processing and restitution system for audio data, comprising:
an analog-to-digital and digital-to-analog converter (2) according to one of the claims 10 to 18,
a signal processor (4) for processing the sequence of digital samples supplied to or received from said converter,
wherein said processor (4) is put in standby mode when a standby-mode signal (9, 35) generated by said converter (2) indicates an absence of significant data in said sequence.

31. Acquisition system according to the preceding claim, wherein said converter (2) comprises at least one output pin for a standby-mode signal, said output pin being connected electrically to a physical interrupt input of said processor (4), said processor comprising a computer module capable of being executed by said processor for detecting any modification of the logical state of the interruption line and for reacting when the latter is at an active level by putting all or part of said system in standby mode.
